## Europäisches Patentamt

## European Patent Office

## Office européen des brevets

(11) Veröffentlichungsnummer: **0 198 149**
**A1**

(12) # EUROPÄISCHE PATENTANMELDUNG

(21) Anmeldenummer: **86100491.9**

(22) Anmeldetag: **16.01.86**

(51) Int. Cl.⁴: **C 03 C 8/14, H 01 C 7/00**

(30) Priorität: **06.02.85 DE 3503928**

(43) Veröffentlichungstag der Anmeldung: **22.10.86**
**Patentblatt 86/43**

(84) Benannte Vertragsstaaten: **AT BE CH DE FR GB IT LI LU NL SE**

(71) Anmelder: **Reimbold & Strick GmbH & Co. KG, Kunftstrasse 4, D-5000 Köln 91 (DE)**

(72) Erfinder: **Cremer, Wilhelm, Dipl.-Ing. (FH), Vorhelmer Weg 99, D-4730 Ahlen (DE)**
Erfinder: **Sölla, Jakob, Württemberger Weg 2, D-5047 Wesseling (DE)**

(74) Vertreter: **Keller, Johanna Carola et al, Deichmannhaus am Hauptbahnhof, D-5000 Köln 1 (DE)**

(54) **Verfahren zur Herstellung eines metallkeramischen Leiters und Anwendung des Verfahrens.**

(57) Die Erfindung betrifft ein Verfahren zur Herstellung eines Leiters, und zwar als selbsttragender, gegebenenfalls pulverisierbarer Körper oder als eine mit einem isolierenden Träger durch einen Brennvorgang bleibend verbundene ganz- oder teilflächige Beschichtung. Bei diesem Verfahren wird eine gemahlene, Dotierungselemente enthaltende Glasfritte mit Siliciumpulver zu einer Zusammensetzung gemischt, die zu dem Körper geformt oder auf den Träger aufgebracht wird. Hieran schließt sich das Brennen des Körpers oder des beschichteten Trägers unter Ausbildung des Leiters an, dessen elektrischer Widerstand, falls erforderlich, durch Formierung stabilisiert werden kann. Verschiedene Anwendungen des Verfahrens werden beschrieben, beispielsweise auch die Anwendung des aus dem gebrannten Körper gewonnenen leitfähigen Pulvers in einer Matrix.

ACTORUM AG

## Verfahren zur Herstellung eines metallkeramischen Leiters und Anwendung des Verfahrens

Die Erfindung betrifft ein Verfahren zur Herstellung eines metallkeramischen Leiters als selbsttragender, gegebenenfalls pulverisierbarer Körper oder als eine mit einem isolierenden Träger durch einen Brennvorgang bleibend verbundene ganz- oder teilflächige Beschichtung.

Metallkeramische Leiter sind in erster Linie auf dem Gebiet der sog. Dickschichttechnik seit langem bekannt. Hier werden auf einen isolierenden Träger beispielsweise mit Hilfe der Siebdrucktechnik Leiterbahnen, Widerstände, Induktivitäten und Kondensatoren aufgebracht, um elektronische Schaltungen zu fertigen. Die zur Anwendung kommenden metallkeramischen Leiter bestehen im wesentlichen aus einem sehr feindispersen Metallpulver aus vorzugsweise Edelmetallen und Edelmetall-Legierungen, insbesondere aus Gold oder Edelmetallen der VIII. Gruppe des Periodischen Systems, und dieses Metallpulver ist mit einer pulverisierten, handelsüblichen Glasfritte vermischt und wird mit einem flüssigen organischen Bindemittel zu einer Paste angeteigt. Diese Paste wird dann meist im Siebdruckverfahren auf den Träger aufgebracht und bei Temperaturen im Bereich von 600 ° bis 900 °C eingebrannt. Bei diesem Brennvorgang schmilzt die Glasfritte und verbindet die Metallteilchen untereinander und mit dem Träger in einem Glasfluß. Die hierbei gebildeten Schichten sind elektrisch leitfähig, und es können Leitwerte bis zu ca. 30 Milliohm/cm² erhalten werden.

Es ist auch schon versucht worden, als leitfähige feindisperse Metalle Kupfer und auch Nickel, das letztgenannte auch in Kombination mit geringen Anteilen an Eisen (DE-AS 11 46 991), einzusetzen, doch sind in diesen Fällen unerwünschte Begleiterscheinungen infolge der leichten Oxidierbarkeit dieser Metalle unvermeidlich, die nicht nur beim Brennen sondern auch beim späteren Gebrauch zu Störungen Anlaß geben, insbesondere bezüglich der mangelnden Langzeitstabilität der erhaltenen Leitwerte.

Die Verwendung dieser aus der Dickschichttechnik bekannten metallkeramischen Leiter als Heizleiter bei entsprechend hoher Strombelastung ist üblicherweise nicht nur unzweckmäßig, sondern insbesondere auch nicht sinnvoll; denn zum einen sind die erreichbaren Temperaturen schon durch den Erweichungspunkt der als Bindemittel eingesetzten Glasfritte begrenzt und zum anderen sind infolge der erheblichen Unterschiede der thermischen Ausdehnungskoeffizienten des isolierenden Trägermaterials, der Glasfritte und insbesondere der leitenden Metallteilchen beim Aufheizen mechanische Spannungen und Rißbildung im metallkeramischen Leiter bzw. im Verbund von Leiter- und Trägermaterial nicht auszuschließen. Hinzukommt, daß die beschriebenen Leiterwerkstoffe auf einen Träger aus isolierenden Werkstoffen angewiesen und nicht dazu geeignet sind, einen frei tragenden Leiter beispielsweise in Form eines Stabes zu bilden. Außerdem handelt es sich bei den oxidationsbeständigen edelmetallhaltigen Metallteilchen um sehr kostspielige Werkstoffe, deren Einsatz nur im Rahmen des niedrigen Verbrauchs bei der Herstellung miniaturisierter elektronischer Dickschichtschaltungen vertretbar ist, während dieser Kostenfaktor bei anderen Verwendungen eine bedeutende Rolle spielt.

Der Erfindung lag die Aufgabe zugrunde, ein Verfahren zur Herstellung eines metallkeramischen Leiters der eingangs beschriebenen Art verfügbar zu machen, das die meisten der oben geschilderten Nachteile nicht aufweist und mit dem insbesondere metallkeramische Leiter hergestellt werden können, die sowohl als selbsttragende, gegebenenfalls pulverisierbare und in diesem Zustand weiter formbare Körper als auch als eine mit einem isolierenden Träger während des Brennvorganges bleibend verbundene ganz- oder teilflächige Beschichtung einstellbare und insbesondere auch reproduzierbare Widerstandswerte aufweisen. Als isolierende Träger kommen hier vorzugsweise Glas und Keramik in Betracht, gegebenenfalls kombiniert mit anderen Werkstoffen.

Die Lösung dieser Aufgabe ist ein Verfahren, das dadurch gekennzeichnet ist, daß eine gemahlene Glasfritte mit einem Gehalt an für die Dotierung von Silicium geeigneten Elementen in Mengen von 2 bis 30 Gew.-%, berechnet als Oxide und bezogen auf die in der Fritte insgesamt vorliegenden Oxide, gemahlen und mit technisch reinem Siliciumpulver zu einer keramischen Zusammensetzung gemischt wird, worauf, und zwar gegebenenfalls entweder unter gleichzeitiger Zugabe eines verdampfbaren flüssigen Dispergiermittels oder späterer Einmischung dieses Dispergiermittels in die trockene Vormischung, Formgebung der Masse oder Beschichtung eines isolierenden Trägers mit der Masse in Abhängigkeit von deren Konsistenz, Brennen des Körpers oder des beschichteten Trägers bei Temperaturen, die in Abhängigkeit vom Schmelzpunkt der Glasfritte gewählt werden und im Bereich von 500 ° bis 1400 °C liegen können, vorzugsweise im Bereich von 700 ° bis 1300 °C, sowie gegebenenfalls anschliessende Stabilisierung des elektrischen Widerstandes des

0198149

gebildeten metallkeramischen Leiters (Formierung) durch eine gegenüber der später zur Anwendung kommenden deutlich höheren Strombelastung erfolgt.

Als Glasfritten können die üblichen, in bezug auf ihre Zusammensetzung dem Fachmann geläufigen Glasfritten eingesetzt werden, beispielsweise solche, die $SiO_2$, $Al_2O_3$, Alkalioxide, Erdalkalioxide und/oder andere niedrig schmelzende Oxide enthalten.

Es hat sich gezeigt, daß in der Glasfritte als für die Dotierung von Silicium geeignete Elemente vorzugsweise Bor und Phosphor geeignet sind, doch können auch andere Dotierungselemente, wie beispielsweise Arsen, sowie die Kombination mehrerer dieser Elemente Bestandteile der Glasfritte sein.

Im Prinzip kommt erfindungsgemäß also ebenfalls ein fein gemahlenes elektrisch leitfähiges Material zum Einsatz, das mit Hilfe einer bei erhöhten Temperaturen schmelzenden pulverförmigen Glasfritte zu einer kompakten Schicht auf einem Träger oder aber unmittelbar zu einem Körper zusammengesintert werden kann, der seinerseits wieder pulverisiert und weiter verarbeitet werden kann. Im Gegensatz zu den bisher bekannten Werkstoffen zur Gewinnung von metallkeramischen Leitern handelt es sich bei dem technisch reinen, also metallurgisch erhaltenen Siliciumpulver jedoch um einen sehr kostengünstig erhältlichen Werkstoff, der sich gegenüber den bisher schon verwendeten unedleren Metallen vor allem dadurch auszeichnet, daß er auch bei hohen Temperaturen durch sein eigenes Oxid vor weiterer Oxidation wirksam geschützt ist.

Ein weiterer wesentlicher Vorteil des Siliciums gegenüber den bisher verwendeten metallischen Werkstoffen ist sein mit dem der einbettenden Glasfritte weitaus besser übereinstimmender thermischer Ausdehnungskoeffizient, durch den bei thermischer Wechselbelastung Beschädigungen des kompakten oder schichtförmigen Leiters infolge thermischer Spannungsrisse verhindert werden.

Andererseits handelt es sich bei Silicium aber um einen Werkstoff mit Halbleitercharakter, so daß der Fachmann an sich erwarten müßte, daß insbesondere auch unter Berücksichtigung der stark schwankenden Reinheit des metallurgisch gewonnenen Siliciumpulvers keine ausreichende und vor allem reproduzierbar eingestellte Leitfähigkeit erreicht werden könnte. Überraschenderweise hat sich erfindungsgemäß aber gezeigt, daß dieses angestrebte Ziel dann erreicht werden kann, wenn über die Glasfritte Elemente mit dem Silicium zusammengeführt werden, die aus der Halbleitertechnik als wirksame Dotierungsstoffe für Silicium bekannt sind, wie u.a. Arsen, Phosphor und insbesondere Bor.

Wie bereits erwähnt, beträgt der Gehalt an diesen Dotierungselementen 2 bis 30 Gew.-%, berechnet als Oxide und bezogen auf die in der Glasfritte insgesamt vorliegenden Oxide, d.h. bei dem Verfahren gemäß der Erfindung wird sehr viel Dotierungselement in das Silicium eingebaut, das auf Grund seiner metallurgischen Herkunft ohnehin bereits große Mengen an Fremdatomen enthält. Infolge der damit verbundenen Exzess-Dotierung verliert das Silicium den Charakter eines Halbleiters und erhält die metallische Leitfähigkeit, die in Verbindung mit der einbettenden Glasfritte beim Verfahren gemäß der Erfindung die Herstellung leitender Körper und leitender Schichten mit einstellbaren, reproduzierbaren Widerstandswerten ermöglicht.

Beim Verfahren gemäß der Erfindung haben sich als keramische Zusammensetzungen solche besonders günstig erwiesen, die aus 20 bis 50 Gew.-% Glasfritte und Rest Siliciumpulver bestehen, jeweils bezogen auf die Gesamtfeststoffe.

Eine Zerkleinerung des Siliciums auf die in der Dickschichttechnik üblichen Feinheiten des Leitmetall-Pulvers im μm-Bereich ist erfindungsgemäß nicht erforderlich, vielmehr kann das Siliciumpulver in einer gewöhnlichen Mahlfraktion mit einem Kornspektrum von 0 bis 120 μm verwendet werden.

Es ist zweckmäßig, in den keramischen Zusammensetzungen beim Verfahren gemäß der Erfindung zusätzlich Schwebemittel zu verwenden; denn durch deren Zusatz kann die Viskosität der Glasfritte günstig beeinflußt und gesteuert werden. Auf Kosten des Siliciumpulvers können diese Schwebemittel in Mengen bis zu 40 Gew.-%, vorzugsweise in Mengen von 5 bis 30 Gew.-%, verwendet werden. Beim Verfahren gemäß der Erfindung haben sich beispielsweise Zusammensetzungen bewährt, die 10 bis 25 Gew.-% Schwebemittel neben 30 Gew.-% borhaltiger Glasfritte und 45 bis 60 Gew.-% Siliciumpulver oder 30 bis 40 Gew.-% Schwebemittel neben 30 Gew.-% borhaltiger Glasfritte und Rest Silicium enthalten. Als Schwebemittel können beispielsweise Bentonite, Tone, Gelatine und pyrogene Kieselsäure (Aerosil) verwendet werden, wobei sich Tone als besonders geeignet erwiesen haben.

Aus den beschriebenen keramischen Zusammensetzungen können erfindungsgemäß stabförmige Leiter hergestellt werden, indem das Ausgangsgemisch in einen rohr- oder wannenartig geformten Tiegel gefüllt, in diesem zu einem Körper gesintert und nach dem Abkühlen aus dem Tiegel gelöst wird. Diese Leiter können anschließend, falls gewünscht, zu Pulver zerkleinert und in einer Matrix eingebettet als Leiterwerkstoff verwendet werden, beispielsweise als leitfähiger Lack.

Leitfähige Schichten auf einem isolierenden Trägermaterial werden durch Auftragen der keramischen Zusammensetzung auf den beispielsweise bereits gebrannten keramischen Träger und anschließendes Sintern hergestellt. Besonders wirtschaftlich ist in diesem Zusammenhang eine Verfahrensvariante, bei der in einem einzigen Brennvorgang der als keramischer Träger eingesetzte Rohscherben gebrannt, die keramische Zusammensetzung gesintert und hierbei das für die Leitfähigkeit der Schicht verantwortliche Siliciumpulver mit dem Dotierungselement aus der Glasfritte dotiert wird.

Um das Aufbringen der keramischen Zusammensetzungen auf die Trägermaterialien zu vereinfachen und auch spezielle Auftragsverfahren, wie beispielsweise Siebdrucktechnik, Gießtechnik, Spritztechnik oder das Aufbringen mittels Abziehbildern zu ermöglichen, kann es von Vorteil und notwendig sein, in den keramischen Zusammensetzungen verdampfbare flüssige Dispergiermittel mit zu verwenden. Als flüssige Dispergiermittel eignen sich neben Wasser beispielsweise zahlreiche organische Verbindungen, Drucköle, deren Viskosität entsprechend der Auftragstechnik variieren kann, sowie wasserverträgliche Druckmedien, insbesondere Polyvinylalkohole.

Beim Verfahren gemäß der Erfindung können die keramischen Zusammensetzungen außer durch unmittelbares Sintern in einem Tiegel, wie oben bereits beschrieben, auch in Form von mit den verdampfbaren Dispergiermitteln angeteigten Pasten zur Herstellung von Formteilen verwendet werden, die nach dem Brennen bei Temperaturen, wie sie für Keramik oder Email üblich sind, leitend sind und einstellbare, reproduzierbare Widerstandswerte aufweisen. Das Aufbringen der keramischen Zusammensetzungen in Form einer Suspension in den verdampfbaren Dispergiermitteln kann erfindungsgemäß ganz- oder teilflächig auf den isolierenden Trägern erfolgen, auf denen dann nach dem Brennen entweder eine ganzflächige leitende Schicht oder aber beliebig geformte Leiterbahnen vorliegen, die ebenfalls einstellbare reproduzierbare Widerstandswerte aufweisen. Die Schichtdicke kann bis 1,0 mm, vorzugsweise 0,1 bis 0,5 mm betragen, liegt also im Bereich der für keramische Glasuren üblichen Schichtdicken, und wird je nach gewünschtem Flächenwiderstand gewählt. Dieser ist beispielsweise bei 0,1 mm Schichtdicke besonders hoch und nimmt dann mit zunehmender Schichtdicke ab.

Bei einer nicht ganzflächigen Beschichtung des isolierenden Trägers können, wie bereits erwähnt, beliebig geformte Leiterbahnen erfindungsgemäß aufgetragen werden. Diese können beliebige geometrische Flächen, wie Rechtecke, Quadrate oder Streifen darstellen. Die Streifen können auch mäanderartig geformt oder spiralförmig sein.

Wie schon angedeutet, kann die den metallischen Leiter beim Brennen bildende keramische Zusammensetzung auf den Träger im Spritzverfahren oder im Gießverfahren

0198149

aufgebracht werden. Daneben ist es möglich und hat sich besonders bewährt, die den metallischen Leiter beim Brennen bildende keramische Zusammensetzung im Siebdruck auf den isolierenden Träger aufzubringen. Auch die Technik des Abziehbildes ist anwendbar.

Anders als bei den mit Edelmetallen gefüllten metallkeramischen Leitern der Dickschichttechnik kann es erforderlich sein, die erfindungsgemäß erhaltenen siliciumhaltigen Leiter vor ihrer Inbetriebnahme zu formieren, indem der Leiter kurzfristig mit einem Strom belastet wird, der deutlich höher ist als der später im Dauerbetrieb durch den Leiter fließende Strom. Hierbei werden die eventuell auf der Oberfläche der Siliciumpartikel noch vorhandenen, den Stromfluß hemmenden Oxidhäutchen dauerhaft durchschlagen, womit ein ungehinderter Stromfluß von Siliciumkorn zu Siliciumkorn durch deren gemeinsame Berührungsfläche stattfinden kann. Die Formierung kann beispielsweise durch Kondensatorentladung erfolgen.

Die Erfindung wird durch die nachstehenden Beispiele weiter erläutert.

Beispiel 1

Um einen stabförmigen Leiter herzustellen, wurde das Ausgangsgemisch, das 40 Gew.-% borhaltige Glasfritte und 60 Gew.-% Siliciumpulver enthielt, in einen rinnen-, rohr- oder wannenartig geformten Tiegel gefüllt. Der Borgehalt der Glasfritte betrug in diesem Falle 15 Gew.-%. In dem Tiegel wurde die Ausgangsmischung zu dem stabförmigen Leiter bei 1200 °C gesintert, dieser nach dem Abkühlen aus dem Tiegel gelöst und anschließend in der beschriebenen Weise formiert.

Beispiel 2

Zur Herstellung eines schichtförmigen Leiters auf einem isolierenden Träger wurde eine Glasur verwendet, die in Form eines Schlickers vorlag und 30 Teile der im Beispiel 1 erwähnten borhaltigen Glasfritte, 60 Teile Silicium und 10 Teile Ton enthielt. Der Auftrag auf die keramische Unterlage erfolgte im Siebdruckverfahren, wobei einerseits der Auftrag auf eine bereits vorgebrannte Keramikfliese erfolgte, zum anderen auf eine noch nicht gebrannte und somit noch schrumpfbare Fliese. In beiden Fällen wurde beim Brennen bei 1250 °C die Glasur fest mit der keramischen Unterlage verbunden.

Der Schlicker wurde in einer Menge von 4,5 g/dm² naß aufgetragen und lieferte nach dem Brennen eine Glasur in einer Schichtdicke von ca. 0,15 mm mit einem Flächenwiderstand um 5 bis 10 Ohm/dm².

Der besondere Vorteil des Verfahrens gemäß der Erfindung besteht darin, daß es bei seiner Anwendung gelingt, leitfähige Beschichtungen nicht nur auf Keramikflächen, sondern auch auf Keramikformkörper und sogar auf isolierte Metalloberflächen aufzubringen, die der direkten oder indirekten elektrischen Beheizung dienen können. Damit ist es erfindungsgemäß beispielsweise möglich, Keramikfliesen auf der Fliesenrückseite leitfähig zu beschichten, um diese Fliesen dann für die Fußboden- und/oder Wandbeheizung einzusetzen. Die Fülle der möglichen Anwendungen des Verfahrens gemäß der Erfindung zur Herstellung metallkeramischer Leiter ergibt sich aus der nachstehenden beispielsweisen Aufzählung von Anwendungen, die aber keinesfalls als vollständig betrachtet werden kann:

Herstellung keramischer Formteile mit leitfähiger Beschichtung zur elektrischen Beheizung im Sinne eines keramischen Tauchsieders oder einer keramischen Heizkerze, gegebenenfalls mit isolierender Schutzglasur;

Herstellung flächiger keramischer Heizkörper, insbesondere Platten hoher Heizleistung bei niedriger Heizleistungsdichte und homogener Wärmeerzeugung für Trockenschränke, Backöfen, Wasch- und Spülmaschinen;

Herstellung großflächiger keramischer Kochplatten (Kochfelder) mit mehreren voneinander getrennten, rückseitig mit gutem Wärmekontakt aufgebrachten Heizschichten;

Herstellung einer Direktheizung keramischer Bauteile der chemischen Industrie, wie beispielsweise Reaktoren oder Rohre, durch außen oder innen aufgebrachte elektrisch beheizte Glasuren;

Herstellung voll gekapselter elektrischer Heizplatten durch Einschließen eines metallkeramischen Heizleiters zwischen zwei isolierende, beispielsweise keramische oder emaillierte Platten;

Herstellung frei tragender metallkeramischer Leiter in Stab- oder Barrenform zur Anwendung als elektrische Heizstäbe.

Neben diesen mehr der Beheizung dienenden Anwendungen ist es aber auch möglich, auf der Rückseite von Keramikfliesen leitfähige Beschichtungen aufzubringen, und zwar großflächig, um diese dann untereinander verbundenen Fliesen als elektrostatische Abschirmung der damit ausgekleideten Räume einzusetzen, beispielsweise in medizinisch-physikalischen Meßräumen, um Störfaktoren auszuschalten. Auch bei hochwertigen elektronischen Dickschicht-Halbleiterschaltkreisen auf keramischen Trägern kann eine leitfähige Rückseitenbeschichtung zum Zwecke der integrierten elektrischen Abschirmung gegen einfallende oder ausstrahlende Störungen von Vorteil sein. Ebenfalls zum Zwecke der Abschirmung kann für hochwertige integrierte Schaltkreise eine leitfähige Außenbeschichtung der keramischen Gehäuse Vorteile bringen. Schließlich kann das Verfahren gemäß der Erfindung auch angewandt werden, um auf keramischen Fliesen eine leitfähige Vorderseitenglasur aufzubringen, die der elektrostatischen Abschirmung dient und die elektrische Aufladung von Fußböden in Räumen mit beispielsweise sehr hoher Explosionsgefahr verhindern, zumindest aber reduzieren hilft. Im letztgenannten Falle ist wegen der dunklen Farbe der Glasur eine spezielle Dekorwirkung auf den Fliesen allerdings erschwert.

0198149

P a t e n t a n s p r ü c h e

1. Verfahren zur Herstellung eines metallkeramischen Leiters als selbsttragender, gegebenenfalls pulverisierbarer Körper oder als eine mit einem isolierenden Träger durch einen Brennvorgang bleibend verbundene ganz- oder teilflächige Beschichtung, dadurch gekennzeichnet, daß eine gemahlene Glasfritte mit einem Gehalt an für die Dotierung von Silicium geeigneten Elementen in Mengen von 2 bis 30 Gew.-%, berechnet als Oxide und bezogen auf die in der Fritte insgesamt vorliegenden Oxide, gemahlen und mit technisch reinem Siliciumpulver zu einer keramischen Zusammensetzung gemischt wird, worauf, und zwar gegebenenfalls entweder unter gleichzeitiger Zugabe eines verdampfbaren flüssigen Dispergiermittels oder späterer Einmischung dieses Dispergiermittels in die trockene Vormischung, Formgebung der Masse oder Beschichtung eines isolierenden Trägers mit der Masse in Abhängigkeit von deren Konsistenz, Brennen des Körpers oder des beschichteten Trägers bei Temperaturen im Bereich von 500 °C bis 1400 °C, sowie gegebenenfalls anschließende Stabilisierung des elektrischen Widerstandes des gebildeten metallkeramischen Leiters (Formierung) durch eine gegenüber der später zur Anwendung kommenden deutlich höheren Strombelastung erfolgt.

2. Verfahren nach Anspruch 1, dadurch gekennzeichnet, daß eine gemahlene Glasfritte eingesetzt wird, die Bor und /oder Phosphor enthält.

3. Verfahren nach Anspruch 1 oder 2, dadurch gekennzeichnet, daß eine keramische Zusammensetzung verwendet wird, die aus 20 bis 50 Gew.-% Glasfritte und Rest Siliciumpulver besteht, jeweils bezogen auf die Gesamtfeststoffe.

4. Verfahren nach Anspruch 1 bis 3, dadurch gekennzeichnet, daß das Siliciumpulver ein Kornspektrum von 0 bis 120 µm aufweist.

5. Verfahren nach Anspruch 1 bis 4, dadurch gekennzeichnet, daß die keramische Zusammensetzung auf Kosten des Siliciumpulvers zusätzlich bis zu 40 Gew.-%, vorzugsweise 5 bis 30 Gew.-%, eines die Viskosität der Glasfritte steuernden Schwebemittels aufweist.

6. Verfahren nach Anspruch 1 bis 5, dadurch gekennzeichnet, daß die keramische Zusammensetzung 30 Gew.-% borhaltige Glasfritte, 10 bis 25 Gew.-% Schwebemittel und 45 bis 60 Gew.-% Siliciumpulver enthält.

7. Verfahren nach Anspruch 1 bis 6, dadurch gekennzeichnet, daß die keramische Zusammensetzung 30 Gew.-% borhaltige Glasfritte, 30 bis 40 Gew.-% Schwebemittel und Rest Siliciumpulver enthält.

8. Verfahren nach Anspruch 1 bis 7, dadurch gekennzeichnet, daß die keramische Zusammensetzung als gegebenenfalls verwendete verdampfbare flüssige Dispergiermittel Wasser, organische Verbindungen, Drucköle auch unterschiedlicher Viskosität, und /oder wasserverträgliche Druckmedien enthält.

0198149

9. Verfahren nach Anspruch 8, dadurch gekennzeichnet, daß die keramische Zusammensetzung als Dispergiermittel Polyvinylalkohole enthält.

10. Verfahren nach Anspruch 1 bis 9, dadurch gekennzeichnet, daß der geformte Körper oder der beschichtete Träger bei Temperaturen von 700 °C bis 1300 °C gebrannt wird.

11. Verfahren nach Anspruch 1 bis 10, dadurch gekennzeichnet, daß der isolierende Träger mit der den metallkeramischen Leiter beim Brennen bildenden Zusammensetzung ganz- oder teilflächig beschichtet wird.

12. Verfahren nach Anspruch 1 bis 11, dadurch gekennzeichnet, daß die Schichtdicke der Zusammensetzung auf dem isolierenden Träger bis zu 1,0 mm, vorzugsweise 0,1 bis 0,5 mm beträgt.

13. Verfahren nach Anspruch 1 bis 12, dadurch gekennzeichnet, daß die den metallischen Leiter beim Brennen bildende Zusammensetzung auf den Rohscherben aufgebracht und mit diesem unter Brennschwindung gleichzeitig in einem einzigen Brennvorgang gebrannt wird.

14. Verfahren nach Anspruch 1 bis 13, dadurch gekennzeichnet, daß die den metallischen Leiter beim Brennen bildende Zusammensetzung auf den isolierenden Träger in Form beliebiger miteinander verbundener geometrischer Flächen aufgebracht wird.

15. Verfahren nach Anspruch 1 bis 14, dadurch gekennzeichnet, daß die den metallischen Leiter beim Brennen bildende Zusammensetzung auf den isolierenden Träger als mäanderartig geformte oder spiralförmige Streifen aufgebracht wird.

16. Verfahren nach Anspruch 1 bis 15, dadurch gekennzeichnet, daß die den metallischen Leiter beim Brennen bildende Zusammensetzung im Spritz- und /oder Gießverfahren aufgebracht wird.

17. Verfahren nach Anspruch 1 bis 15, dadurch gekennzeichnet, daß die den metallischen Leiter beim Brennen bildende Zusammensetzung im direkten oder indirekten Siebdruck auf den isolierenden Träger aufgebracht wird.

18. Anwendung des Verfahrens nach irgendeinem der Ansprüche 1 bis 17 zur Herstellung von leitfähigen Beschichtungen für die direkte oder indirekte (rückseitige) elektrische Beheizung von Glas- und /oder Keramikflächen und/oder -formkörpern.

19. Anwendung des Verfahrens nach irgendeinem der Ansprüche 1 bis 17 zur Herstellung von leitfähigen Beschichtungen für die direkte oder indirekte elektrische Beheizung isolierend beschichteter Metalloberflächen.

20. Anwendung des Verfahrens nach irgendeinem der Ansprüche 1 bis 7 zur Herstellung von leitfähigen Sinterformteilen.

21. Anwendung des Verfahrens nach irgendeinem der Ansprüche 1 bis 7 zur Herstellung leitfähiger Pulver.

0198149

# Europäisches Patentamt

## EUROPÄISCHER RECHERCHENBERICHT

Nummer der Anmeldung

EP 86 10 0491

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int Cl.4) |
|---|---|---|---|
| A | PATENT ABSTRACTS OF JAPAN, Band 2, Nr. 75 (E-78)[2991], 14. Juni 1978; & JP - A - 53 040 898 (MATSUSHITA DENKI SANGYO K.K.) 13.04.1978 | 1,3,20,21 | C 03 C 8/14<br>H 01 C 7/00 |
| A | PATENT ABSTRACTS OF JAPAN, Band 2, Nr. 75 (E-78)[2991], 14. Juni 1978; & JP - A - 53 040 897 (MATSUSHITA DENKI SANGYO K.K.) 13.04.1978 | 1-3,20,21 | |
| A | PATENT ABSTRACTS OF JAPAN, Band 1, Nr. 86 (E-77)[1968], 11. August 1977; & JP - A - 52 022 794 (MATSUSHITA DENKI SANGYO K.K.) 21.02.1977 | 1,18,20,21 | |
| A | PATENT ABSTRACTS OF JAPAN, Band 1, Nr. 114 (E-77)[4302], 30. September 1977; & JP - A - 52 046 499 (MATSUSHITA DENKI SANGYO K.K.) 13.04.1986 | 1,20,21 | |
| A | CHEMICAL ABSTRACTS, Band 100, Nr. 16, 16. April 1984, Seite 634, Spalte 1, Abstract Nr. 130917y, Columbus, Ohio, US; & JP - A - 58 197 826 (HITACHI LTD.) 17.11.1983 | 1,2 | |

RECHERCHIERTE SACHGEBIETE (Int. Cl.4)

C 03 C 4/00
C 03 C 8/00
C 03 C 14/00
H 01 C 7/00
H 01 C 8/00

--- -/-

Der vorliegende Recherchenbericht wurde für alle Patentansprüche erstellt.

| Recherchenort BERLIN | Abschlußdatum der Recherche 18-04-1986 | Prüfer STROUD J.G. |
|---|---|---|

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503 03 82

# Europäisches Patentamt

## EUROPÄISCHER RECHERCHENBERICHT

Seite 2

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | CHEMICAL ABSTRACTS, Band 100, Nr. 14, 2. April 1984, Seite 646, Spalte 2, Abstract Nr. 113405n, Columbus, Ohio, US; & JP - A - 58 194 356 (NIPPON ELECTRIC CO. LTD.) 12.11.1983 --- | 1,2 | |
| A | US-A-3 542 609 (H.M. BOHNE et al.) * Zusammenfassung * --- | 1,2 | |
| A | US-A-3 986 905 (P.M. GARAVAGLIA) * Spalte 1, Zeile 29 - Spalte 2, Zeile 47 * --- | 1,2 | |
| P,X | GB-A-2 152 027 (GROUP SERVICES LTD.) * Ansprüche 1,4-13; Seite 9, Zeilen 36-43; Beispiele * | 1,10 | |
| P,A | * Ansprüche 5,10-12 * --- | 4,5,8 | RECHERCHIERTE SACHGEBIETE (Int. Cl.4) |
| A | US-A-3 748 171 (J. PEELING) * Ansprüche 1,5; Tabelle VII * ----- | | |

Der vorliegende Recherchenbericht wurde für alle Patentansprüche erstellt.

| Recherchenort BERLIN | Abschlußdatum der Recherche 18-04-1986 | Prüfer STROUD J.G. |
|---|---|---|